(19) **Europäisches Patentamt / European Patent Office / Office européen des brevets**

(11) **EP 2 929 535 B1**

(12) **FASCICULE DE BREVET EUROPEEN**

(45) Date de publication et mention de la délivrance du brevet:
**20.09.2017 Bulletin 2017/38**

(21) Numéro de dépôt: **13801586.2**

(22) Date de dépôt: **06.12.2013**

(51) Int Cl.:
*G11C 11/22* *(2006.01)*    *G11C 11/44* *(2006.01)*
*G11C 11/54* *(2006.01)*    *G11C 11/56* *(2006.01)*
*G11C 13/00* *(2006.01)*    *H01L 39/22* *(2006.01)*
*H01L 27/18* *(2006.01)*    *H01L 45/00* *(2006.01)*
*H01C 7/10* *(2006.01)*

(86) Numéro de dépôt international:
**PCT/EP2013/075840**

(87) Numéro de publication internationale:
**WO 2014/086990 (12.06.2014 Gazette 2014/24)**

(54) **RESISTANCE REGLABLE**

VARISATOR

VARISTOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **07.12.2012 FR 1203321**

(43) Date de publication de la demande:
**14.10.2015 Bulletin 2015/42**

(73) Titulaires:
• **Thales**
  **92400 Courbevoie (FR)**
• **CNRS (Centre National de la Recherche Scientifique)**
  **75016 Paris Cedex 16 (FR)**

(72) Inventeurs:
• **BRIATICO, Javier**
  **F-91767 Palaiseau Cedex (FR)**
• **VILLEGAS, Javier**
  **F-91767 Palaiseau Cedex (FR)**
• **BERNARD, Rozenn**
  **F-91767 Palaiseau Cedex (FR)**

(74) Mandataire: **Brunelli, Gérald et al**
**Marks & Clerk France**
**Immeuble Visium**
**22, avenue Aristide Briand**
**94117 Arcueil Cedex (FR)**

(56) Documents cités:
**FR-A1- 2 954 855**     **JP-A- H06 169 112**
**US-A1- 2002 180 006**

## Description

L'invention concerne le domaine des composants électroniques et notamment des résistances. Plus particulièrement, l'invention concerne des résistances réglables par commande électrique comportant une structure hybride comprenant un matériau supraconducteur et un matériau ferroélectrique.

Le domaine d'application de ce type de structure concerne les dispositifs limiteur de signaux ou des applications dans des systèmes neuromorphiques.

La publication « Nanoscale Electrostatic Manipulation of Magnetic Flux Quanta in Ferroelectric/Superconductor BiFeO3/YBaCu3O7, Heterostructures » de Crassous et al. Physical Review Letters, 107, 247000 (2011) met en évidence la faisabilité du dopage d'un matériau supraconducteur d'une structure hybride comprenant un empilement de deux couches : une première couche d'un matériau supraconducteur et une deuxième couche d'un matériau ferroélectrique.

Le principe de ce dopage repose sur la création d'un champ électrique dans le deuxième matériau ferroélectrique. Le deuxième matériau ferroélectrique est polarisé ou possède une composante de sa polarisation selon une direction parallèle à la direction de l'empilement. L'orientation du champ électrique du deuxième matériau ferroélectrique induit soit un défaut de porteurs de charges dans le premier matériau supraconducteur, le premier matériau supraconducteur étant dans un état sous-dopé par rapport au même matériau en absence du deuxième matériau ferroélectrique, soit un excès de porteurs de charges dans le premier matériau supraconducteur, le premier matériau supraconducteur étant alors dans un état sur-dopé par rapport au même matériau supraconducteur en absence de deuxième matériau ferroélectrique. Le dopage d'un matériau supraconducteur permet de déplacer la température critique du premier matériau supraconducteur, la température critique du premier matériau supraconducteur étant la température en dessous de laquelle la résistance du premier matériau supraconducteur est négligeable.

Le document de Crassous *et al.* présente un dispositif permettant, d'une part, de visualiser à l'aide d'un microscope à force atomique, ou AFM pour « Atomic Force microscope » en langue anglaise, le sens de polarisation du deuxième matériau ferroélectrique après application d'une tension électrique entre le cantilever et le premier matériau supraconducteur, le cantilever étant une pointe atomique conductrice de l'AFM permettant, en l'espèce, d'appliquer une tension à la surface du premier matériau. La résistance du film supraconducteur est obtenue par la mesure de la tension produite par le passage d'un courant de valeur connu.

Le dispositif proposé par la publication de Crassous *et al.* comprend une structure hybride, sous la forme d'un barreau, comprenant une première couche de matériau supraconducteur comprenant de l'YBaCu$_3$O$_7$, noté YBCO, et une deuxième couche de matériau ferroélectrique comprenant du BiFeO$_3$, noté BFO. Le BFO est un matériau ferroélectrique connu pour ses propriétés de forte rémanence permettant de réaliser le dopage du premier matériau supraconducteur de la structure hybride de manière « non volatile ». En l'espèce, le deuxième matériau ferroélectrique a une structure de type pérovskite, il est réalisé selon des conditions connues de l'homme de l'art qui permettent d'atteindre une accumulation de charges allant jusqu'à environ 100 $\mu$C.cm$^{-2}$ selon une direction (111).

On entend par « structure non volatile », une structure qui conserve ses propriétés après l'arrêt de l'application de la tension électrique. En d'autres termes, le sens de polarisation de la deuxième couche ferroélectrique reste inchangé après l'arrêt de l'application de la tension électrique. Par voie de conséquence, l'état de dopage du premier matériau supraconducteur reste inchangé après l'arrêt de l'application de la tension électrique.

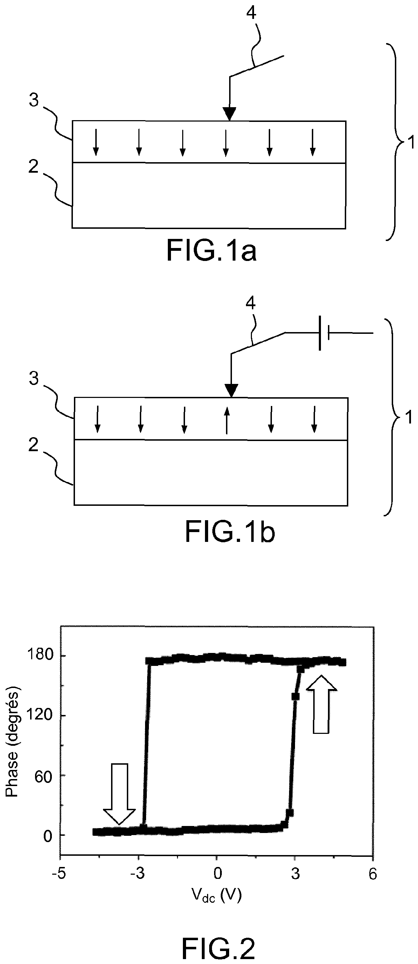

Les figures 1 a et 1b représentent une structure hybride selon l'art connu.

La figure 1a représente la structure hybride 1 comprenant un empilement d'un premier matériau supraconducteur 2 et un deuxième matériau ferroélectrique 3 au repos. En d'autres termes, aucune tension n'est appliquée entre le cantilever 4 de l'AFM et la première couche de matériau supraconducteur 2. La polarisation de la deuxième couche de matériau ferroélectrique 3 est homogène.

En l'espèce, la polarisation de la deuxième couche de matériau ferroélectrique 3 est orientée vers la première couche de matériau supraconducteur 2, autrement dit vers le « bas ». L'orientation de la polarisation du deuxième matériau ferroélectrique 3 est représentée par des flèches orientées de haut en bas. Selon les mesures publiées par Crassous et al., si une tension de -4,5 V est appliquée entre le cantilever 4 de l'AFM et la première couche de matériau supraconducteur 2, le sens de polarisation de la deuxième couche de matériau ferroélectrique 3 reste inchangée, la polarisation du deuxième matériau 3 reste homogène et orientée de haut en bas. L'augmentation continue de la tension appliquée jusqu'à une valeur inférieure à 3V ne modifie pas l'orientation de la polarisation, celle-ci demeurant homogène sur l'ensemble de la deuxième couche de matériau ferroélectrique 3.

La figure 1b représente la structure hybride 1, une tension électrique est imposée entre le cantilever 4 de l'AFM et la première couche de matériau supraconducteur 2, la tension imposée étant égale ou supérieure à 3V. L'orientation de la polarisation de la deuxième couche de matériau 3 est localement inversée. L'inversion locale de polarisation est représentée par une flèche orientée de bas en haut située en dessous du cantilever 4 de l'AFM. Le sens de polarisation est orienté localement de bas en haut générant localement un excès de porteurs de charges dans le premier matériau supraconducteur 2 permettant son sur-dopage. La polarisation locale de la deuxième couche de matériau 3 restera dans ce nouvel état orienté de bas en haut même si la tension électrique entre le cantilever 4 de l'AFM et la première couche de matériau supraconducteur 2 devient nulle.

Le sens de polarisation de la deuxième couche de matériau ferroélectrique 3 peut à nouveau être inversé localement par application d'une tension inférieure à -3V entre le cantilever 4 de l'AFM et la première couche de matériau supraconducteur 2.

Les figures 1a et 1b mettent bien en évidence un changement de sens de polarisation obtenu pour une valeur de tension électrique continue supérieure en valeur absolue à une valeur de tension électrique de seuil Us, en l'espèce la tension électrique de seuil Us est égale à 3V.

La figure 2 représente le cycle d'hystérésis du deuxième matériau ferroélectrique 3 comprenant du BFO.

Cette représentation graphique a été réalisée à partir d'une structure hybride 1 telle que décrite précédemment. Cette figure met à nouveau en évidence, l'existence d'une tension électrique de seuil Us au dessus de laquelle, en valeur absolue, l'orientation de la polarisation du deuxième matériau ferroélectrique 3 est inversée. Cette valeur de tension Us de seuil permet de générer un champ électrique d'intensité au moins égale à l'intensité du champ électrique de renversement Er. On entend par champ électrique de renversement, le champ permettant d'inverser l'orientation de la polarisation du deuxième matériau ferroélectrique 3 selon la direction parallèle à la direction de l'empilement.

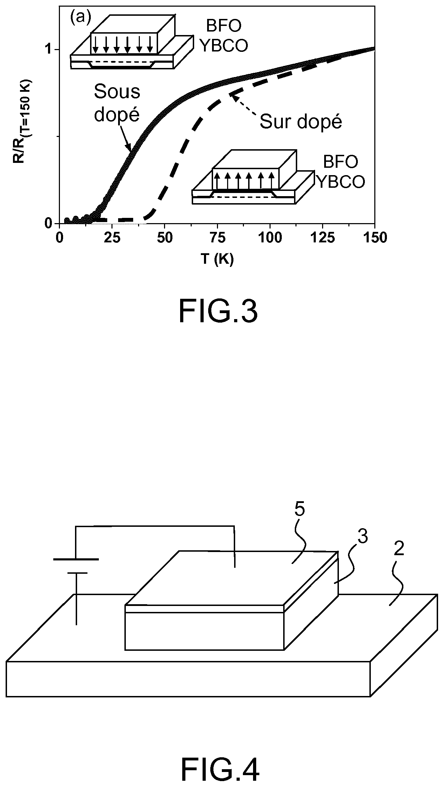

La figure 3 représente la résistance d'une structure hybride 1 telle que décrite précédemment en fonction de la température et en fonction de l'état de dopage de la première couche de matériau supraconducteur 2.

Pour déterminer les valeurs de résistances, la structure hybride 1 est traversée par une densité de courant électrique de 1,7 kA.cm$^{-2}$.

Des premières mesures de la tension électrique en fonction de la température aux bornes d'une première zone correspondant à l'état sous-dopé du premier matériau supraconducteur 2, et, des deuxièmes mesures de la tension aux bornes d'une deuxième zone correspondant à l'état sur-dopé du premier matériau supraconducteur 2 ont été réalisées. Les résistances en fonction de la température sont ensuite déduites des mesures de tension effectuées pour l'état sur-dopé et l'état sous-dopé de la première couche de matériau supraconducteur 2.

Une première courbe, représentée en trait plein, correspond à l'évolution des résistances déterminées du premier matériau supraconducteur 2 à l'état sous-dopé en fonction de la température.

Sur un premier domaine de températures compris entre 0K et 14K, la résistance du premier matériau supraconducteur 2 est quasiment nulle. Sur un deuxième domaine de températures compris entre 14K et 150K, la résistance du premier matériau supraconducteur 2 augmente fortement avec la température. Une première température critique Tc1 du premier matériau supraconducteur 2 à l'état sous-dopé peut être mise en évidence, la première température critique Tc1 étant égale à 14K. En dessous de cette première température critique Tc1, la résistance du premier matériau supraconducteur 2 est négligeable.

Une deuxième courbe, représentée en trait discontinu, correspond à l'évolution des résistances déterminées du premier matériau supraconducteur 2 à l'état sur-dopé en fonction de la température.

Sur un troisième domaine de températures compris entre 0 et 37K, la résistance du premier matériau supraconducteur 2 est quasiment nulle. Sur un quatrième domaine de températures compris entre 37K et 150K, la résistance augmente fortement avec la température. Une deuxième température critique Tc2 du premier matériau supraconducteur 2 à l'état dopé est égale à 37K, en dessous de cette température la résistance du premier matériau supraconducteur 2 est négligeable.

Les courbes représentant l'évolution des résistances d'une structure hybride 1 en fonction de la température pour un premier matériau supraconducteur 2 à l'état dopé et à l'état non dopé ont une allure similaire. La deuxième température critique Tc2, correspondant à l'état sur-dopé du premier matériau supraconducteur 2, est supérieure à la première température critique Tc1, correspondant à l'état sous-dopé du premier matériau supraconducteur 2. Cette différence de températures critiques entre l'état sur-dopé et l'état sous-dopé du premier matériau supraconducteur 2 permet de définir un premier intervalle de températures ΔT1 sur lequel la différence des résistances entre l'état sur-dopé et l'état sous-dopé du premier matériau supraconducteur 1 est non nulle pour une température d'utilisation donnée. En l'espèce, cet intervalle de températures est compris entre 14K et au moins 150K. La température de 150 K est la plus élevée atteinte lors de la réalisation des expériences représentées sur la figure 3. Cependant, une différence non nulle des résistances est attendue pour toutes températures supérieures à la première température critique Tc1. La différence des résistances la plus importante est observée dans l'intervalle de températures compris entre Tc1 et Tc2.

Par conséquent, le changement d'état du premier matériau supraconducteur 2 sur l'intervalle de températures supérieures à 14 K permet de faire varier la résistance de la structure hybride 1.

La figure 4 représente une première application d'une structure hybride 1 selon l'art connu.

La structure hybride 1 comprend l'empilement de la première couche du matériau supraconducteur 2, la deuxième couche du matériau ferroélectrique 3 et une électrode ou grille supérieure comprenant un matériau conducteur 5. Une tension électrique continue est appliquée entre l'électrode conductrice 5 et le premier matériau supraconducteur 2. L'application d'une tension négative ou positive permet de changer localement, sous la grille supérieure, le sens de polarisation de la deuxième couche de matériau ferroélectrique 3 de manière non volatile, le changement du sens de polarisation étant réversible par simple application d'une tension électrique de valeur opposée. Le changement du sens de polarisation engendre un changement d'état du premier matériau supraconducteur 2 qui passera alors d'un état sous-dopé à un état sur-dopé, ou inversement. Pour une température de fonctionnement donnée comprise dans le premier intervalle de températures ΔT1, le changement d'état du premier matériau supraconducteur 2 d'un état sous-dopé à un état sur-dopé induit une diminution de la résistance du matériau supraconducteur. A l'inverse, le changement d'état du premier matériau supraconducteur 2 d'un état sur-dopé à un état sous-dopé induit une augmentation de la résistance du premier matériau supraconducteur 2.

Ce dispositif permet le passage en mode « interrupteur » d'une valeur de résistance à une autre. En optimisant le choix de la température de fonctionnement, ce dispositif permet en mode « interrupteur » le passage ou le blocage du courant. Le dispositif proposé, selon l'art connu, ne permet pas une variation graduelle de la résistance.

Le document US 2002/180006 (Franz Marcel et al.) divulgue de manière similaire une résistance électrique réglable par commande électrique à effet mémoire, comportant une première couche d'un empilement supraconducteur, une deuxième couche d'un deuxième matériau ferroélectrique et une troisième couche d'un matériau conducteur. Un moyen de commande en tension électrique entre la première couche de matériau supraconducteur et la troisième couche de matériau conducteur peut générer un champ électrique permettant de modifier le sens de polarisation du deuxième matériau ferroélectrique lorsque la tension électrique de commande est supérieure à une valeur de tension de seuil.

Le dispositif proposé selon l'invention permet de réaliser une résistance variable commandable électriquement à effet mémoire.

Selon un aspect de l'invention, il est proposé une résistance électrique réglable à effet mémoire comprenant :

- un empilement comprenant :

  - une première couche d'un premier matériau supraconducteur possédant un premier état sous-dopé de première température critique et un deuxième état sur-dopé de deuxième température critique, la deuxième température critique étant supérieure à la première température critique, la première couche s'étendant selon un axe x,

  - une deuxième couche d'un deuxième matériau ferroélectrique polarisée ou ayant une composante de sa polarisation selon une direction parallèle à la direction de l'empilement, l'état du premier matériau dépendant du sens de polarisation du deuxième matériau, et

  - une troisième couche d'un troisième matériau conducteur,

- un moyen de commande en tension électrique entre la première et la troisième couche, générant un champ électrique permettant de modifier le sens de polarisation du deuxième matériau lorsque la tension électrique de commande est supérieure à une tension électrique de seuil et génère un champ électrique en surface du deuxième matériau ferroélectrique supérieur au champ de renversement.

L'empilement comprend en outre une quatrième couche d'au moins un quatrième matériau électriquement isolant, la quatrième couche étant disposée entre la deuxième couche et la troisième couche, l'épaisseur de la quatrième couche variant selon une direction parallèle à l'axe x et/ou la quatrième couche comprend une succession de matériaux selon l'axe x de constantes diélectriques différentes de manière à faire varier le champ électrique appliqué entre la troisième couche du troisième matériau conducteur et la première couche du premier matériau supraconducteur, la résistance réglable étant configurée pour fonctionner sur un intervalle de températures sur lequel la différence de résistance électrique entre l'état sur-dopé et l'état sous-dopé du premier matériau est non nulle.

Le dispositif ainsi réalisé permet de faire varier la résistance électrique de la première couche de matériau supraconducteur en fonction de la tension appliquée entre la première couche de matériau supraconducteur et la troisième couche de matériau conducteur. Le dispositif conserve par ailleurs la dernière valeur de résistance commandée après l'arrêt de l'application de la tension électrique.

Préférentiellement, l'épaisseur de la quatrième couche augmente continument selon une direction parallèle à la direction de l'axe x permettant de faire varier continument la valeur de la résistance.

Avantageusement, le premier matériau est un supraconducteur à haute température critique, les systèmes de refroidissement associés étant de faibles dimensions et nécessitant de faible quantité d'énergie.

Avantageusement, le premier matériau supraconducteur est de l'YBa$_2$Cu$_3$O$_7$, ou du NdBa$_2$Cu$_3$O$_{7-x}$ ou tout autre matériau supraconducteur de la famille des ReBa$_2$CuO$_{7-x}$, Re étant un matériau de la famille des terres rares, ou tout autre matériau supraconducteur de la famille des cuprates.

Avantageusement, le deuxième matériau ferroélectrique conserve le sens de polarisation défini par l'application de la tension électrique après l'arrêt de l'application de la tension électrique, typiquement le deuxième matériau ferroélectrique est du BiFeO$_3$ ou du BaTiO$_3$.

L'invention sera mieux comprise à l'étude de quelques modes de réalisation décrits à titre d'exemples nullement limitatifs, et illustrés par des dessins annexés sur lesquels :

- les figures 1a et 1b, déjà décrites, illustrent un dispositif permettant de mettre en évidence le dopage d'un matériau supraconducteur compris dans une structure hybride, selon l'art connu,

- la figure 2 représente le cycle d'hystérésis du BFO, selon l'art connu,

- la figure 3, déjà décrite, représente l'évolution de la résistance d'une structure hybride BFO/YBCO en fonction de la température pour l'état sur-dopé et sous-dopé du premier matériau supraconducteur YBCO, selon l'art connu,

- la figure 4, déjà décrite, représente une première application de la structure hybride, selon l'art connu,

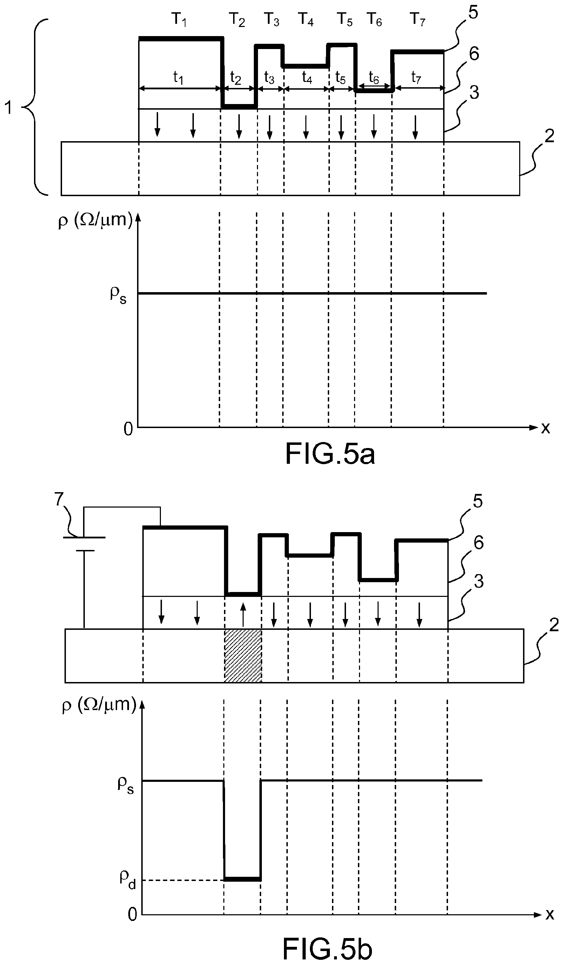

- les figures 5a à 5c représentent un mode de réalisation de la résistance réglable, selon un aspect de l'invention, et

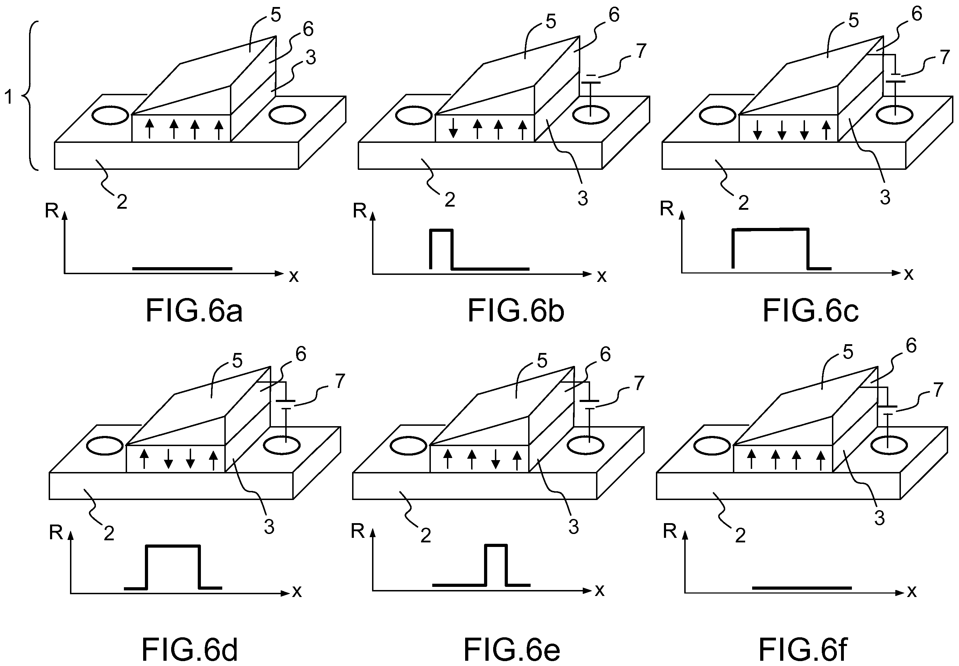

- les figures 6a à 6f représentent un mode de réalisation privilégié de la résistance réglable, selon un aspect de l'invention.

Les figures 5a à 5c représentent un mode de réalisation de la résistance réglable.

La résistance réglable comprend une structure hybride 1 comprenant une première couche de matériau supraconducteur 2, une deuxième couche de matériau ferroélectrique 3, une troisième couche de matériau conducteur 5 et une quatrième couche de matériau électriquement isolant 6 disposée entre la deuxième 3 et la troisième 5 couche.

La première couche de matériau supraconducteur 2 comprend avantageusement un matériau supraconducteur de haute température critique telle que de l'YBCO. Le matériau supraconducteur 2 de haute température critique peut être associé à un système de refroidissement de petite dimension et de faible consommation énergétique. La première couche du premier matériau supraconducteur 2 s'étend sur une longueur selon un axe x.

La deuxième couche de matériau ferroélectrique 3 est disposée sur la première couche de matériau supraconducteur 2. Préférentiellement, le deuxième matériau ferroélectrique 3 possède une forte polarisation rémanente permettant d'élaborer une structure non volatile.

La quatrième couche de matériau électriquement isolant 6 est disposée sur la deuxième couche du matériau ferroélectrique 3, l'épaisseur de la quatrième couche isolante 6 est variable de manière à obtenir, pour une même tension appliquée sur la troisième couche de matériau conducteur 5, différentes valeurs de champ électrique dans la deuxième couche du matériau ferroélectrique 3.

En l'espèce, les variations d'épaisseurs sont obtenues par une découpe de la face supérieure de la quatrième couche de matériau permettant de définir une succession de tranches, notées Ti, de longueur ti, dans la structure hybride 1, selon l'axe x.

Selon une variante de l'invention, il est possible de réaliser les tranches Ti à partir de matériaux isolants de constantes diélectriques différentes.

Une troisième couche de matériau conducteur électrique 5 est disposée sur la face supérieure de la quatrième couche de matériau isolant 6. La troisième couche de matériau conducteur 5 permet d'appliquer une tension électrique entre de la première couche de matériau supraconducteur 2 et la troisième couche de matériau conducteur 5.

La température de fonctionnement Tf est supérieure à la première température critique TC1. Préférentiellement, la température de fonctionnement Tf correspond à une température pour laquelle la différence entre les résistances du premier matériau supraconducteur 2 à l'état sur-dopé et sous-dopé est maximale, notamment sur le premier intervalle de température $\Delta$T1.

La figure 5a représente la résistance réglable telle que décrite ci-dessus au repos, ou, en d'autres termes, lorsque le sens de polarisation est orienté du haut vers le bas sur toutes les tranches Ti de la structure hybride 1, le sens de polarisation du deuxième matériau ferroélectrique 3 étant représenté par des flèches, et que aucune tension électrique n'est appliquée entre la quatrième couche de matériau conducteur 5 et la première couche de matériau supraconducteur 2. L'orientation de haut en bas de la polarisation engendre un déficit de porteurs de charge dans la première couche de matériau supraconducteur 2, sur toutes les zones situées en vis-à-vis des tranches Ti, le matériau supraconducteur 2 est à l'état sous-dopé.

Les résistances élémentaires Ri des N tranches Ti sont égales à ps.ti, ps étant la valeur de la résistance par unité de longueur de la couche de matériau supraconducteur à l'état sous-dopé et ti étant une dimension d'une tranche Ti selon l'axe x. Les résistances élémentaires Ri des N tranches pouvant être assimilées à des résistances en série, la résistance totale $R_T$ du premier matériau supraconducteur 2 est égale à la somme des N résistances élémentaires Ri des différentes tranches Ti. Dans ce cas, la résistance totale $R_T$ du matériau supraconducteur 2 est égale à $\rho_s \sum\limits_{i=1}^{N} t_i$ .

La figure 5b représente la résistance réglable pendant l'imposition d'une première tension électrique U1 à l'aide d'un moyen de commande 7. La première tension U1 imposée est égale à la tension électrique de seuil Us, la tension électrique de seuil Us étant la tension nécessaire pour générer un champ électrique d'intensité égale à l'intensité du champ électrique de renversement Er de la polarisation en absence de la quatrième couche de matériau électriquement isolant 6. En raison des différentes épaisseurs du quatrième matériau isolant 6, les champs électriques appliqués sur le deuxième matériau ferroélectrique 3 sur les différentes tranches Ti sont différents.

Le quatrième matériau électriquement isolant 6 correspondant à la première tranche T1 étant relativement épais, la tension U1 appliquée entre la troisième couche de matériau conducteur 5 et la première couche de matériau supraconducteur 2 produit un champ électrique dans le deuxième matériau ferroélectrique 3 dans la tranche T1 inférieur au champ électrique de renversement Er. Par voie de conséquence, le sens de polarisation du deuxième matériau ferroélectrique 3 correspondant à la première tranche T1 n'est pas modifié.

Pour des raisons identiques, le sens de polarisation du deuxième matériau ferroélectrique 3 correspondant aux tranches T3 à T7 n'est pas modifié.

L'épaisseur du quatrième matériau isolant 6 correspondant à la deuxième tranche T2 étant nulle, la tension U1 appliquée entre la troisième couche de matériau conducteur 5 et la première couche de matériau supraconducteur 2 étant égale à la tension Us, et par conséquent, le champ électrique sur la tranche T2 du deuxième matériau ferroélectrique 3 est égale au champ électrique de renversement Er. Le sens de polarisation du deuxième matériau ferroélectrique 3 correspondant à la deuxième tranche T2 est inversé. L'orientation inversée du deuxième matériau ferroélectrique 3 est représentée par une flèche orientée de bas en haut sur la figure 5b. L'orientation de la polarisation du deuxième matériau ferroélectrique sur la deuxième tranche T2 engendre un excès de porteurs de charges dans la première couche de matériau supraconducteur 2 sur la deuxième tranche T2. Le premier matériau supraconducteur 2 est à l'état sur-dopé, avec une résistance par unité de longueur pd, représentée par une zone hachurée sur la figure 5b. La résistance par unité de longueur à l'état sur-dopé pd est inférieure à la résistance par unité de longueur à l'état sous-dopé ps. En particulier, pd est nulle si le dispositif est utilisé à une température comprise dans l'intervalle de températures compris entre Tc1 et Tc2. La résistance totale $R_T$ dans le cas générale est égale à

$$\left( \sum_{i=1}^{N} \rho_s \left( t_i - t_2 \right) + \rho_d t_2 \right).$$

Le deuxième matériau ferroélectrique 3 utilisé ayant une forte polarisation rémanente, l'orientation de la polarisation du deuxième matériau ferroélectrique 3 sur les N tranches Ti reste inchangée après l'arrêt de l'application de la tension U1, et, de ce fait, la résistance totale $R_T$ reste alors égale à $\left( \sum_{i=1}^{N} \rho_s \left( t_i - t_2 \right) + \rho_d t_2 \right)$ après l'arrêt de l'application de la tension U1.

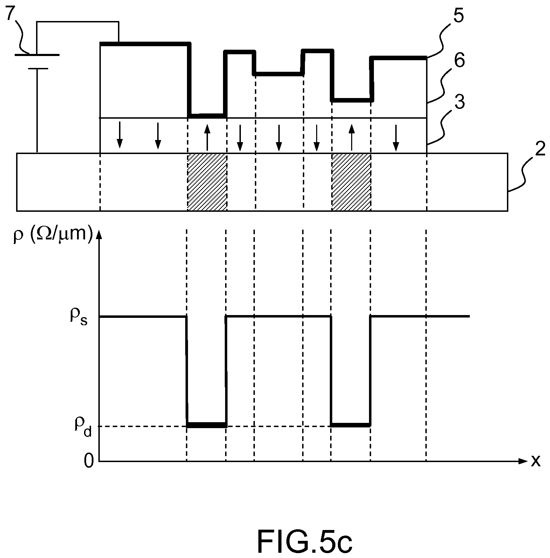

La figure 5c représente la résistance réglable pendant l'application d'une deuxième tension U2, la deuxième tension U2 étant supérieure à la tension électrique de seuil Us. L'épaisseur de la quatrième couche de matériau isolant 6 correspondant à la sixième tranche T6 étant relativement mince, la tension appliquée entre la troisième couche de matériau conducteur 5 et la première couche de matériau supraconducteur 2 produit un champ électrique au moins égale au champ électrique de renversement Er sur la sixième tranche T6. Le sens de polarisation du deuxième matériau ferroélectrique 3 correspondant à la sixième tranche T6 est inversé. La résistance totale $R_T$ est alors égale à

$$\left( \sum_{i=1}^{N} \rho_s \left( t_i - t_2 - t_6 \right) + \rho_d \left( t_2 + t_6 \right) \right).$$

L'application d'une troisième tension U3 de valeur absolu égale à U2 mais de signe contraire, produira un champ électrique suffisant pour assurer le renversement de la polarisation sur les tranches T2 et T6 du deuxième matériau ferroélectrique 3, et de ce fait revenir à l'état de la figure 5a.

Les figures 5a à 5c présentent un mode de réalisation de la résistance réglable et mettent en évidence la possibilité de faire varier la valeur de la résistance totale à l'aide d'une commande électrique.

Les figures 6a à 6f représentent un mode de réalisation privilégié de la résistance réglable, selon un aspect de l'invention.

La résistance réglable comprend une structure hybride comprenant la première couche supraconductrice 2 d'YBCO, la deuxième couche ferroélectrique 3 de BFO, la troisième couche conductrice 5 d'or, et la quatrième couche de matériau isolant disposée entre la deuxième et la troisième couche. La quatrième couche de matériau forme une rampe selon une direction parallèle à l'axe x permettant un réglage fin de la résistance.

Afin de donner des ordres de grandeur de taille de la structure hybride, la deuxième couche ferroélectrique 3 de BFO peut avoir une épaisseur de 30 nm. La première couche supraconductrice 2 d'YBCO peut avoir une épaisseur correspondant à 3 unités de maille cristalline. La largeur selon l'axe y de la structure hybride peut être égale à 10 μm.

Dans ce mode de réalisation, une tension électrique de seuil Us égale à 3V ou -3V permet de changer l'orientation de la polarisation de la deuxième couche ferroélectrique 3 de BFO, lorsque celle-ci est directement au contact de la troisième couche conductrice 5 d'or.

La résistance déterminée pour une structure hybride 1 telle que décrite de la première couche d'YBCO à l'état sous-dopé et pour une longueur selon l'axe x de 10 μm est de l'ordre de 2000 ohms.

La figure 6a représente la structure hybride au repos, la première couche ferroélectrique 3 de BFO est à l'état sur-dopé, la résistance est négligeable sur l'ensemble de la première couche supraconductrice 2 d'YBCO comme l'indique la courbe représentative de la résistance élémentaire Ri le long de l'axe x. La résistance totale $R_T$ de la structure hybride 1 étant la somme des résistances élémentaires Ri, en l'espèce la résistance totale de la structure hybride 1 est nulle.

La figure 6b représente la structure hybride lorsqu'on impose une tension négative sensiblement supérieure à la tension de seuil Us qui génère sur la couche ferroélectrique 3 un champ électrique de renversement Er de la polarisation. Sur une première portion de la structure hybride 1, la tension appliquée entre la troisième couche conductrice 5 d'or et la première couche supraconductrice 2 d'YBCO produit le renversement de la polarisation de la couche ferroélectrique 3, la première portion correspond à une zone sur laquelle la quatrième couche de matériau isolant 6 a une épaisseur très fine. La première couche d'YBCO correspondant à cette première portion passera alors de l'état sur-dopé à l'état sous-dopé. La résistance de la première portion de la première couche 2 d'YBCO est alors égale à une résistance Ri. La première résistance $R_{T1}$ totale devient non nulle.

En augmentant progressivement la valeur absolue de la tension négative imposée entre la première couche supraconductrice 2 d'YBCO et la troisième couche conductrice 5 d'or, une deuxième portion de la couche supraconductrice 2 passe à l'état -sous-dopé, comme indiqué sur la figure 6c. La deuxième zone comprenant la première zone. Il est possible de créer une deuxième résistance $R_{T2}$, la deuxième résistance totale $R_{T2}$ de la première couche conductrice 2 d'YBCO étant supérieure à la première résistance totale $R_{T1}$.

La figure 6d représente la structure hybride 1 lorsqu'on impose une tension positive sensiblement supérieure à la tension Us de seuil à la structure hybride 1 telle que représentée sur la figure 6c. Sur la première portion de la structure hybride 1, la tension appliquée entre la troisième couche conductrice 5 d'or et la première couche supraconductrice 2 d'YBCO produira un champ électrique supérieur ou égale au champ de renversement de la polarisation de la couche ferroélectrique 3. La première couche 2 d'YBCO correspondant à cette première portion repassera de l'état sous-dopé à l'état sur-dopé. La résistance de la première portion de la première couche 2 d'YBCO est alors nulle. Il est possible de créer une troisième résistance $R_{T3}$, la troisième résistance totale $R_{T3}$ de la première couche supraconductrice 2 d'YBCO étant inférieure à la deuxième résistance totale $R_{T2}$.

En augmentant la tension imposée entre la première couche supraconductrice 2 d'YBCO et la troisième couche conductrice 5 d'or de la structure hybride telle que représentée sur la figure 5d, une troisième portion de la couche supraconductrice 2 passe à l'état sur-dopé, comme indiqué sur la figure 6e. La troisième portion comprenant la première portion. Il est possible de créer une quatrième résistance $R_{T4}$, la quatrième résistance totale $R_{T4}$ de la première couche conductrice 2 d'YBCO étant inférieure à la troisième résistance totale $R_{T3}$.

Si la première couche de matériau supraconducteur 2 d'YBCO est à l'état sur-dopé au repos, l'application d'une tension négative, supérieure à la tension Us de seuil et de plus en plus grande en valeur absolue permettra d'augmenter progressivement la valeur de la résistance totale jusqu'à atteindre une valeur de résistance totale maximale. Ensuite, l'application d'une tension positive, supérieure à la tension Us de seuil et de plus en plus grande permettra de diminuer progressivement la valeur de la résistance totale jusqu'à atteindre une valeur de résistance totale nulle.

Le dispositif proposé permet de réaliser une résistance réglable par commande électrique, la résistance conservant sa valeur même après l'arrêt de l'application de la tension électrique de commande.

**Revendications**

1. Résistance électrique réglable par commande électrique, à effet mémoire, comprenant

   • un empilement comprenant :

      - une première couche d'un premier matériau supraconducteur (2) possédant un premier état sous-dopé de première température critique (Tc1) et un deuxième état surdopé de deuxième température critique (Tc2), la deuxième température critique (Tc2) étant supérieure à la première température critique (Tc1), la première couche de matériau supraconducteur (2) s'étendant selon un axe x ,
      - une deuxième couche d'un deuxième matériau ferroélectrique (3) polarisée ou ayant une composante de sa polarisation selon une direction parallèle à la direction de l'empilement, l'état du premier matériau (2) dépendant du sens de polarisation du deuxième matériau (3), et
      - une troisième couche d'un troisième matériau conducteur (5),

   • un moyen de commande (7) en tension électrique entre la première couche de matériau supraconducteur (2) et la troisième couche de matériau conducteur (5), générant un champ électrique permettant de modifier le sens de polarisation du deuxième matériau ferroélectrique (3) lorsque la tension électrique de commande est supérieure à une valeur de tension (Us) de seuil,

   le deuxième matériau ferroélectrique (3) conservant le sens de polarisation défini par l'application de la tension électrique après l'arrêt de l'application de la tension électrique,
   **caractérisée en ce que** l'empilement comprend en outre une quatrième couche comprenant au moins un quatrième matériau électriquement isolant (6), la quatrième couche (6) étant disposée entre la deuxième couche de matériau ferroélectrique (3) et la troisième couche de matériau conducteur (5), l'épaisseur de la quatrième couche électriquement isolante (6) variant selon une direction parallèle à l'axe x et/ou la quatrième couche comprend une succession de matériaux de constante diélectrique différente selon une direction parallèle à l'axe x, de manière à faire varier le champ électrique appliqué entre la première couche (2) et la troisième couche (5), la résistance réglable étant configurée pour fonctionner sur un intervalle de températures sur lequel l'écart de résistance électrique entre l'état sur-dopé et l'état sous-dopé du premier matériau est non nul.

**2.** Résistance réglable selon la revendication 1 dans laquelle l'épaisseur de la quatrième couche électriquement isolante (6) augmente continument selon une direction parallèle à l'axe des x.

**3.** Résistance réglable selon l'une des revendications précédentes dans laquelle le premier matériau (2) est un supraconducteur à haute température critique.

**4.** Résistance réglable selon la revendication 3 dans laquelle le premier matériau supraconducteur (2) comprend du $YBa_2Cu_3O_{7-x}$, ou du $NdBa_2Cu_3O_{7-x}$ ou tout autre matériau supraconducteur de la famille des $ReBa_2CuO_{7-x}$, Re étant un matériau de la famille des terres rares, ou tout autre matériau supraconducteur de la famille des cuprates.

**5.** Résistance réglable selon la revendication 4 dans laquelle le deuxième matériau (3) comprend du $BiFeO_3$ ou $BaTiO_3$.

**Patentansprüche**

**1.** Elektrischer Speichereffektwiderstand, der durch elektrische Steuerung justierbar ist und Folgendes umfasst:

    • einen Stapel, der Folgendes umfasst:

        - eine erste Schicht aus einem ersten supraleitenden Material (2) mit einem ersten unterdotierten Zustand mit einer ersten kritischen Temperatur (Tc1) und einem zweiten überdotierten Zustand mit einer zweiten kritischen Temperatur (Tc2), wobei die zweite kritische Temperatur (Tc2) höher ist als die erste kritische Temperatur (Tc1), wobei die erste Schicht aus supraleitendem Material (2) entlang einer x-Achse verläuft;
        - eine zweite Schicht aus einem zweiten ferroelektrischen Material (3), das polarisiert ist oder eine Komponente seiner Polarisation in einer Richtung parallel zur Richtung des Stapels hat, wobei der Zustand des ersten Materials (2) von der Polarisationsrichtung des zweiten Materials (3) abhängt; und
        - eine dritte Schicht aus einem dritten leitenden Material (5);

    • ein Mittel (7) zum Regeln der elektrischen Spannung zwischen der ersten Schicht aus supraleitendem Material (2) und der dritten Schicht aus leitendem Material (5) zum Erzeugen eines elektrischen Feldes, das die Modifikation der Polarisationsrichtung des zweiten ferroelektrischen Materials (3) zulässt, wenn die elektrische Steuerspannung höher ist als ein Schwellenspannungswert (Us),

wobei das zweite ferroelektrische Material (3) die Polarisationsrichtung behält, die durch das Anlegen der elektrischen Spannung nach dem Stoppen des Anlegens der elektrischen Spannung definiert wird, **dadurch gekennzeichnet, dass** der Stapel ferner eine vierte Schicht umfasst, die wenigstens ein viertes elektrisches isolierendes Material (6) umfasst, wobei die vierte Schicht (6) zwischen der zweiten Schicht aus ferroelektrischem Material (3) und der dritten Schicht aus leitendem Material (5) angeordnet ist, wobei die Dicke der vierten elektrisch isolierenden Schicht (6) in einer Richtung parallel zur x-Achse variiert, und/oder die vierte Schicht eine Folge von Materialien mit einer anderen Dielektrizitätskonstante in einer Richtung parallel zur x-Achse umfasst, um das zwischen der ersten Schicht (2) und der dritten Schicht (5) angelegte elektrische Feld zu varüeren, wobei der justierbare Widerstand zum Arbeiten über ein Temperaturintervall konfiguriert ist, in dem die Abweichung des elektrischen Widerstands zwischen dem überdotierten Zustand und dem unterdotierten Zustand des ersten Materials ungleich null ist.

**2.** Justierbarer Widerstand nach Anspruch 1, wobei die Dicke der vierten elektrisch isolierenden Schicht (6) in einer Richtung parallel zur x-Achse kontinuierlich zunimmt.

**3.** Justierbarer Widerstand nach einem der vorherigen Ansprüche, wobei das erste Material (2) ein Supraleiter mit hoher kritischer Temperatur ist.

**4.** Justierbarer Widerstand nach Anspruch 3, wobei das erste supraleitende Material (2) $YBa_2Cu_3O_{7-x}$ oder $NdBa_2Cu_3O_{7-x}$ oder ein beliebiges anderes supraleitendes Material aus der Familie der $ReBa_2CuO_{7-x}$ umfasst, wobei Re ein Material aus der Seltenerdfamilie oder ein beliebiges anderes supraleitendes Material aus der Cupratfamilie ist.

**5.** Justierbarer Widerstand nach Anspruch 4, wobei das zweite Material (3) BiFeO$_3$ oder BaTiO$_3$ umfasst.

**Claims**

**1.** An electrically adjustable electrical memory effect resistor comprising:

• a stack comprising:

- a first layer of a first superconductive material (2) having a first underdoped state with a first critical temperature (Tc1) and a second overdoped state with a second critical temperature (Tc2), the second critical temperature (Tc2) being higher than the first critical temperature (Tc1), the first layer of superconductive material (2) extending along an axis x;
- a second layer of a second ferroelectric material (3) that is polarised or has a component of its polarisation in a direction parallel to the direction of the stack, the state of the first material (2) depending on the polarisation direction of the second material (3); and
- a third layer of a third conductive material (5);

• a means (7) for controlling the electric voltage between the first layer of superconductive material (2) and the third layer of conductive material (5), generating an electric field allowing the polarisation direction of the second ferroelectric material (3) to be modified when the electric control voltage is higher than a threshold voltage value (Us),

the second ferroelectric material (3) maintaining the polarisation direction that is defined by the application of the electric voltage after the application of the electric voltage has stopped, **characterised in that** the stack further comprises a fourth layer comprising at least one fourth electrically insulating material (6), the fourth layer (6) being disposed between the second layer of ferroelectric material (3) and the third layer of conductive material (5), the thickness of the fourth electrically insulating layer (6) varying in a direction parallel to the axis x and/or the fourth layer comprises a succession of materials with a different dielectric constant in a direction parallel to the axis x, so as to vary the electric field applied between the first layer (2) and the third layer (5), the adjustable resistor being configured to operate over a temperature interval, in which the difference in electric resistance between the overdoped state and the underdoped state of the first material is non-zero.

**2.** The adjustable resistor according to claim 1, wherein the thickness of the fourth electrically insulating layer (6) continuously increases in a direction parallel to the axis x.

**3.** The adjustable resistor according to any one of the preceding claims, wherein the first material (2) is a high critical temperature superconductor.

**4.** The adjustable resistor according to claim 3, wherein the first superconductive material (2) comprises YBa$_2$Cu$_3$O$_{7-x}$ or NdBa$_2$Cu$_3$O$_{7-x}$ or any other superconductive material from the ReBa$_2$CuO$_{7-x}$ family, with Re being a material from the rare-earth family or any other superconductive material from the cuprate family.

**5.** The adjustable resistor according to claim 4, wherein the second material (3) comprises BiFeO$_3$ or BaTiO$_3$.

FIG.1a

FIG.1b

FIG.2

FIG.3

FIG.4

FIG.5a

FIG.5b

FIG.5c

FIG.6a

FIG.6b

FIG.6c

FIG.6d

FIG.6e

FIG.6f

EP 2 929 535 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2002180006 A, Franz Marcel

**Littérature non-brevet citée dans la description**

- **CRASSOUS et al.** Nanoscale Electrostatic Manipulation of Magnetic Flux Quanta in Ferroelectric/Superconductor BiFeO3/YBaCu3O7, Heterostructures. *Physical Review Letters,* 2011, vol. 107, 247000